# EUROPÄISCHE PATENTSCHRIFT

(11) **EP 3 503 724 B1**
(45) Veröffentlichungstag und Bekanntmachung des Hinweises auf die Patenterteilung: **08.05.2024**
(21) Anmeldenummer: 17754351.9
(22) Anmeldetag: 17.08.2017
(51) Int. Cl.: A01M 7/00, A01M 21/04, A01N 25/00, A01P 13/00

(54) **BEKÄMPFUNG VON SCHADORGANISMEN AUF BASIS DER VORHERSAGE VON BEFALLSRISIKEN**
CONTROL OF PESTS BASED ON THE PREDICTION OF INFESTATION RISKS
LUTTE CONTRE DES ORGANISMES NUISIBLES SUR LA BASE DE PREDICTION DE RISQUES DE CONTAMINATION

(30) Priorität: 24.08.2016 EP 16185503
(43) Veröffentlichungstag der Anmeldung: 03.07.2019
(73) Patentinhaber: BASF Agro Trademarks GmbH, 67056 Ludwigshafen am Rhein (DE)
(72) Erfinder: PETERS, Ole, 40217 Düsseldorf (DE); HOLGER, Hoffmann, 42781 Haan (DE); KAROLINE, Epke, 48167 Münster (DE)
(74) Vertreter: BASF IP Association
(86) Internationale Anmeldenummer: PCT/EP2017/070877
(87) Internationale Veröffentlichungsnummer: WO 2018/036909

(56) Entgegenhaltungen:
- WO-A1-01/97097
- HENNING NORDMEYER: "Patchy weed distribution and site-specific weed control in winter cereals", PRECISION AGRICULTURE, KLUWER ACADEMIC PUBLISHERS, BO, Bd. 7, Nr. 3, 31. August 2006 (2006-08-31) , Seiten 219-231, XP019437304, ISSN: 1573-1618, DOI: 10.1007/S11119-006-9015-8
- J. CEPL ET AL: "Weed Mapping-A Way to Reduce Herbicide Doses", POTATO RESEARCH., Bd. 53, Nr. 4, 16. Dezember 2010 (2010-12-16), Seiten 359-371, XP055299534, NL ISSN: 0014-3065, DOI: 10.1007/s11540-010-9173-y
- P Hamouz ET AL: "Impact of site-specific weed management on herbicide savings and winter wheat yield", Plant Soil Environ., 1. März 2013 (2013-03-01), Seiten 101-107, XP055299585, Gefunden im Internet: URL:http://www.agriculturejournals.cz/publ icFiles/82944.pdf [gefunden am 2016-09-02]
- Martina Koller ET AL: "Site-specific herbicide applications based on weed maps provide effective control", CALIFORNIA AGRICULTURE, 1 July 2005 (2005-07-01), pages 182-187, XP055299577, DOI: 10.3733/ca.v059n03p182 Retrieved from the Internet: URL:https://ucanr.edu/repositoryfiles/ca59 03p182-69222.pdf [retrieved on 2016-09-02]
- C S Thomas ET AL: "Utilization of GIS/GPS-Based Information Technology in Commercial Crop Decision Making in California, Washington, Oregon, Idaho, and Arizona", Journal of Nematology, 1 September 2002 (2002-09-01), pages 200-206, XP055526793, United States Retrieved from the Internet: URL:http://journals.fcla.edu/jon/article/v iewFile/69406/67066 [retrieved on 2018-11-26]

## Beschreibung

Die vorliegende Erfindung befasst sich mit der Bekämpfung von Schadorganismen, die beim Anbau von Kulturpflanzen auftreten können. Die Bekämpfung erfolgt auf der Basis der Vorhersage von teilflächenspezifischen Befallsrisiken.

WO 01/97097 A1 offenbart ein Verfahren, um Schadorganismen in einem landwirtschaftlichen Feld mit Kulturpflanzen zu bekämpfen. Hierbei werden Behandlungskarten erzeugt, die das Applizieren verschiedener Produkte - wie Saatgut, Düngemittel, Pflanzenschutzmittel etc. - auf dem Feld definieren.

Martina Koller et al. ("Site-specific herbicide applications based on weed maps provide effective control", California Agriculture, 1. Juli 2005 (2005-07-01), Seiten 182-187, DOI: 10.3733/ca.v059n03p182, URL https://ucanr.edu/repositoryfiles/ca5903p182-69222.pdf) offenbart standortspezifische Herbizidempfehlungskarten basierend auf Unkrautverteilungskarten, wobei u.a. die räumliche Verteilung der Unkrautsamen der vergangenen Jahre berücksichtigt wird. C.S. Thomas et al. ("Utilization of GIS/GPS-Based Information Technology in Commercial Crop Decision Making in California, Washington, Oregon, Idaho, and Arizona", Journal of Nematology, 1. September 2002 (2002-09-01), Seiten 200-206, United States, URL: http://journals.fcla.edu/jon/article/viewFile/69406/67066) offenbart die Nutzung von Wetterdaten und Daten des Mikroklimas, des Entwicklungsstandes der Pflanzen sowie der geographischen Daten, um das Befallsrisiko von Kulturpflanzen mit Schadorganismen zu bestimmen.

Derzeitige Prognosemodelle zum Risiko eines Schädlings- bzw. Krankheitsbefalls basieren oftmals auf Wetterdaten auf Feldebene oder gröberer räumlicher Auflösung.

Das Entscheidungsunterstützungssystem proPlant Expert (Newe et al. 2003, Johnen et al. 2010; www.proPlantexpert.com) verwendet Daten zur Kultur (Entwicklungsstadium, Wachstumsbedingungen, Pflanzenschutzmaßnahmen), zur Witterung (Temperatur, Sonnenscheindauer, Windgeschwindigkeit, Niederschlag) sowie zu Schädlingen / Krankheiten (ökonomische Grenzwerte, Schädlings-/Krankheitsdruck). Mit Hilfe dieser Daten wird ein feldspezifisches Befallsrisiko abgeschätzt und eine Empfehlung zu Behandlungszeitpunkt, Pflanzenschutzmittel sowie eine Bewertung vergangener Pflanzenschutzmaßnahmen erstellt.

Entsprechend der Krankheit bzw. dem Schädling können insbesondere der aktuelle Krankheits-/Schädlingsdruck durch Sichtung im Feld, die Fruchtfolge, die Distanz zu einem Feld mit der gleichen Frucht im Vorjahr sowie der Befall im Vorjahr berücksichtigt werden. Die Abschätzung des Risikos kann hierbei unterschiedlich erfolgen, der Krankheit bzw. dem Schädling entsprechend. So kann das zugrundeliegende Modell z.B. Entwicklungszyklen oder die Migration von Schädlingen berücksichtigen (Johnen et al. 2010). Im Allgemeinen ist dieses System regelbasiert bzw. heuristisch in Kombination mit prozessbasierten Berechnungen (z.B. Abschätzung der Blattfeuchte). Die so erstellten Handlungsempfehlungen zu Behandlungszeitpunkt und Pflanzenschutzmittel sind feldspezifisch, aber nicht teilflächenspezifisch.

Weitere Entscheidungsunterstützungssysteme sind bekannt (Knight & Mumford 1994, Knight 1997).

Neben solchen Entscheidungsunterstützungssystemen, die teilweise die Modellierung einer Vielzahl von Schädlingen- bzw. Krankheiten enthält, finden sich in der Literatur eine Vielzahl von Modellen zur Entwicklung einzelner Krankheiten bzw. Schädlinge (Peterson & Higley 2001). Diese Modelle können regel- oder prozessbasiert sowie auch rein statistisch bzw. datengestützt/empirisch sein. Ferner können diese Modelle generisch sein und unter Anpassung der Modellparameter wiederum für mehrere Krankheiten oder Schädlingen verwendet werden, z.B. EPIWHEAT (Savary 2015) oder WHEATPEST (Willocquet 2008).

Im Allgemeinen kann mithilfe reiner Krankheits- bzw. Schädlingsbefallsmodelle ein Risiko eines Befalls (z.B. proPlant Expert) abgeschätzt werden, während mithilfe gekoppelter Modelle Pflanze-Krankheit bzw. Pflanze-Schädling auch der Einfluss von Krankheit oder Schädling auf die Entwicklung der Kulturpflanzen einschließlich Ertrag abgeschätzt werden kann (z.B. WHEATPEST, Willocquet 2008).

Die erwähnten Entscheidungsstützungssysteme und Modelle sind i.d.R. sogenannte Punktmodelle. Hierbei werden die Modelle i.d.R. so kalibriert, dass der Output die räumliche Repräsentanz des Inputs wiederspiegelt. Ist der Input an einem Punkt im Raum erhoben oder wird für einen Punkt im Raum interpoliert oder geschätzt, so wird i.d.R. angenommen, dass der Modelloutput für das gesamte angrenzende Feld gültig ist. Eine Anwendung von auf Feldebene kalibrierten sog. Punktmodellen auf weitere, i.d.R. gröbere Skalen ist bekannt (Hoffmann et al., 2016). Eine Anwendung dieser sog. Punktmodelle auf mehrere Punkte innerhalb eines Feldes ermöglicht hierbei eine teilflächenspezifische Modellierung des Befalls. Hierbei werden allerdings räumliche Abhängigkeiten bzw. Ausbreitungsvektoren eines Befalls vernachlässigt.

Andererseits existieren auch Systeme zur räumlich expliziten Modellierung von Krankheiten und Schädlingen. Diese Modelle simulieren explizit die zeitlich-räumliche Ausbreitung von Krankheiten oder Schädlingen. Hierbei werden räumliche Abhängigkeiten bzw. Ausbreitungsvektoren eines Befalls berücksichtigt. Ein Beispiel ist die Kombination der Systeme APSIM (prozess-basierte Simulation) und DYMEX (räumliche Modellierung in 2d), (Parry et al., 2011).

In Entscheidungsunterstützungssystemen (s.o.) werden Prognosemodelle überwiegend angewendet, um den Zeitpunkt eines Befalls abzuschätzen und entsprechende eradikative oder kurative Pflanzenschutzmaßnahmen zu ergreifen.

Ansätze zur teilflächenspezifischen bzw. variablen Applikation von Pestiziden basieren auf der aktuell beobachteten Biomasse bzw. Blattfläche, wobei i.d.R. mit zunehmender Biomasse oder Blattfläche mehr Pflanzenschutzmittel (PSM) ausgebracht wird. Der Mehraufwand kann hierbei durch eine höhere Konzentration des Wirkstoffes an der Düse (mg/L) bei gleicher Ausbringung als auch durch eine höhere Ausbringung (L) bei gleicher Konzentration des Wirkstoffes erreicht werden. Diese Ansätze berücksichtigen weder das lokale Risiko durch Krankheiten oder Schädlinge noch den tatsächlichen lokalen Krankheits-/Schädlingsbefall.

Aktuelle Verfahren schätzen den allgemeinen Krankheits- oder Schädlingsdruck eines Feldes mithilfe von 1) Scouting im Feld, 2) Probenahme- und Analyseverfahren (z.B. Auszählen von Sporen, genetische Analyse im Labor zur Identifizierung u./o. Quantifizierung der Pilze), 3) Informationen zu Krankheits- bzw. Schädlingsrisikofaktoren im Vorjahr (z.B. Distanz zum Feld gleicher Kultur im Vorjahr, oder aus dem unspezifischen normalisierten und differenzierten Vegetationsindex (NDVI, engl.: "Normalized Differenced Vegetation Index" oder auch "Normalized Density Vegetation Index) hergeleitete Stresskarten aus dem Vorjahr) sowie 4) Informationen zur tatsächlichen Ausprägung von Krankheits- bzw. Schädlingsbefall im Vorjahr.

Die aktuellen praktikablen Verfahren sind somit räumlich nicht oder wenig differenziert. Zudem berücksichtigen sie langfristige Vektoren nicht. Insbesondere ist eine Kombination von räumlich hochaufgelöstem Pflanzenschutz (Risikovorhersage, Applikation) unter Berücksichtigung solcher langfristigen Vektoren nicht bekannt. So können aber konstante oder langfristige Umweltfaktoren (Boden, Feldrandbewuchs mit Gehölzen, Lage, Exposition) zu konstanten räumlichen Krankheits- oder Schädlingsgradienten oder anderen räumlichen Unterschieden (Teilflächen) führen. Eine räumlich differenzierte Applikation ist hier wünschenswert, um
1) den aktuellen Befall effizient und bedarfsorientiert zu bekämpfen (bei Pilzbefall häufig auch kurativ, bevor das Pathogen sichtbar wird),
2) ggf. biotische Vektoren langfristig zu schwächen (z.B. Schädlinge mit Wirtswechsel, Unkrautnester).

Diese Aufgabe wird durch die Gegenstände der unabhängigen Ansprüche 1 und 8 gelöst. Bevorzugte Ausführungsformen finden sich in den abhängigen Ansprüchen und in der nachfolgenden Beschreibung.

Ein erster Gegenstand der vorliegenden Erfindung ist damit ein

Verfahren zur Bekämpfung von Schadorganismen in einem Feld, in dem Kulturpflanzen angebaut werden, wobei das Verfahren folgende Schritte umfasst:
(A) Erstellen einer ersten Befallskarte, wobei in der ersten Befallskarte Teilflächen in dem Feld verzeichnet sind, in denen in einer vergangenen Anbauperiode ein Befall mit Schadorganismen beobachtet worden ist, und
(B) Erstellen einer zweiten Befallskarte, wobei in der zweiten Befallskarte Teilflächen in dem Feld verzeichnet sind, in denen in der laufenden Anbauperiode ein Befall mit Schadorganismen beobachtet worden ist,
   und
(C) teilflächenspezifische Vorhersage des Befallsrisikos der Kulturpflanzen mit Schadorganismen für die laufende Anbauperiode, wobei die Vorhersage
   - auf Basis der ersten Befallskarte und auf Basis der zweiten Befallskarte und
   - auf Basis von teilflächenspezifischen Informationen zum Entwicklungsstand der Kulturpflanzen und/oder auf Basis von teilflächenspezifischen Umweltfaktoren und
   - auf Basis von Wetterinformationen,
      erfolgt,
      und
(D)Erstellen einer Behandlungskarte, wobei in der Behandlungskarte angegeben ist, welche Teilflächen des Feldes behandelt werden sollen, um die Ausbreitung von Schadorganismen zu verhindern und/oder Schadorganismen zu bekämpfen, wobei die Behandlungskarte
   - auf Basis der Vorhersage des Befallsrisikos für die laufende Anbauperiode erstellt, und
   - auf Basis der für den Zeitpunkt der geplanten Behandlung vorhergesehenen Bedingungen in Bezug auf Wetter, und/oder Entwicklungsstand der Kulturpflanze und/oder Umweltfaktoren erstellt und/oder angepasst wird,
      und
(E) Behandeln von Teilflächen des Feldes gemäß der Behandlungskarte,
   wobei die Vorhersage in Schritt (C) durch Modellierung der Ausbreitung von Schadorganismen mittels eines regel- oder prozessbasierten Modells erfolgt und die folgenden Parameter in die Modellierung einfließen:
   a) Wetter,
   b) Boden,
   c) Kulturpflanze,
   d) Kulturmaßnahmen,
   e) Entwicklungsstand der Kulturpflanze,
   f) aktueller Befall,
   g) Geographie.

Ein weiterer Gegenstand der vorliegenden Erfindung ist ein System zur Bekämpfung von Schadorganismen in einem Feld, in dem Kulturpflanzen angebaut werden, umfassend
(A) eine erste Befallskarte, wobei in der ersten Befallskarte Teilflächen in dem Feld verzeichnet sind, in denen in einer vergangenen Anbauperiode ein Befall mit Schadorganismen beobachtet worden ist, und
(B) eine zweite Befallskarte, wobei in der zweiten Befallskarte Teilflächen in dem Feld verzeichnet sind, in denen in der laufenden Anbauperiode ein Befall mit Schadorganismen beobachtet worden ist,
   und
(C) Mittel zur Vorhersage des Befallsrisikos der Kulturpflanzen mit Schadorganismen für die laufende Anbauperiode, wobei die Vorhersage
   - auf Basis der ersten Befallskarte und auf Basis der zweiten Befallskarte,
      und
   - auf Basis von teilflächenspezifischen Informationen zum Entwicklungsstand der Kulturpflanzen und/oder auf Basis von teilflächenspezifischen Umweltfaktoren,
      und
   - auf Basis von Wetterinformationen,
      erfolgt,
      und
(D)Mittel zum Erstellen einer Behandlungskarte, wobei in der Behandlungskarte angegeben ist, welche Teilflächen des Feldes behandelt werden sollen, um die Ausbreitung von Schadorganismen zu verhindern und/oder Schadorganismen zu bekämpfen, wobei die Behandlungskarte
   - auf Basis der Vorhersage des Befallsrisikos für die laufende Anbauperiode erstellt,
      und
   - auf Basis der für den Zeitpunkt der geplanten Behandlung vorhergesehenen Bedingungen in Bezug auf Wetter, und/oder Entwicklungsstand der Kulturpflanze und/oder Umweltfaktoren erstellt und/oder angepasst wird,
      und
(E) Mittel zur Behandlung von Teilflächen des Feldes gemäß der Behandlungskarte, wobei die Vorhersage in Schritt (C) durch Modellierung der Ausbreitung von Schadorganismen mittels eines regel- oder prozessbasierten Modells erfolgt und die folgenden Parameter in die Modellierung einfließen:
   a) Wetter,
   b) Boden,
   c) Kulturpflanze,
   d) Kulturmaßnahmen,
   e) Entwicklungsstand der Kulturpflanze,
   f) aktueller Befall,
   g) Geographie.

Die Erfindung wird nachstehend näher erläutert, ohne zwischen den Erfindungsgegenständen (Verfahren, Systeme, Computerprogrammprodukt, Behandlungskarte, Verwendung) zu unterscheiden. Die nachfolgenden Erläuterungen sollen vielmehr für alle Erfindungsgegenstände in analoger Weise gelten, unabhängig davon, in welchem Kontext (Verfahren, Systeme, Computerprogrammprodukt, Behandlungskarte, Verwendung) sie erfolgen.

Die Schritte (C) und (D) des erfindungsgemäßen Verfahrens sind obligatorisch. Schritt (E) ist obligatorisch und von den Schritten (A) und (B) ist beide Schritte ((A) und (B)) obligatorisch. Es ergibt sich demnach die folgende Ausführungsform:
(A), (B), (C), (D), (E). Analoges gilt für das erfindungsgemäße System.

In Schritt (A) des erfindungsgemäßen Verfahrens wird eine erste Befallskarte erzeugt. In der ersten Befallskarte sind Orte auf dem Feld verzeichnet, bei denen in der Vergangenheit Schadorganismen beobachtet worden sind.

Unter einem "Schadorganismus" wird nachfolgend ein Organismus verstanden, der beim Anbau von Kulturpflanzen in Erscheinung treten und die Kulturpflanze schädigen, die Ernte der Kulturpflanze negativ beeinflussen oder mit der Kulturpflanze um natürliche Ressourcen konkurrieren kann. Beispiele für derartige Schadorganismen sind Unkräuter, Ungräser, tierische Schädlinge wie beispielsweise Käfer, Raupen und Würmer, Pilze und Krankheitserreger (z.B. Bakterien und Viren). Auch wenn Viren aus biologischer Sicht nicht zu den Organismen zählen, sollen sie dennoch vorliegend unter den Begriff Schadorganismus fallen.

Unter dem Begriff "Unkraut" (Mehrzahl: Unkräuter) werden Pflanzen der spontanen Begleitvegetation (Segetalflora) in Kulturpflanzenbeständen, Grünland oder Gartenanlagen verstanden, die dort nicht gezielt angebaut werden und z.B. aus dem Samenpotential des Bodens oder über Zuflug zur Entwicklung kommen. Der Begriff ist nicht auf Kräuter im eigentlichen Sinne beschränkt, sondern umfasst auch Gräser, Fame, Moose oder holzige Pflanzen.

Im Bereich des Pflanzenschutzes wird häufig auch der Begriff "Ungras" (Mehrzahl: Ungräser) benutzt, um eine Abgrenzung zu den krautigen Pflanzen zu verdeutlichen. Im vorliegenden Text wird der Begriff Unkraut als Oberbegriff verwendet, der den Begriff Ungras mit erfassen soll, es sei denn, es wird auf spezifische Unkräuter oder Ungräser Bezug genommen.

Ungräser und Unkräuter im Sinne der vorliegenden Erfindung sind demnach Pflanzen, die beim Anbau einer gewünschten Kulturpflanze als Begleitung auftreten. Da sie mit der Kulturpflanze um Ressourcen konkurrieren, sind sie unerwünscht und sollen daher bekämpft werden.

Unter dem Begriff "Feld" wird ein räumlich abgrenzbarer Bereich der Erdoberfläche verstanden, der landwirtschaftlich genutzt wird, indem auf einem solchen Feld Kulturpflanzen angepflanzt, mit Nährstoffen versorgt und geerntet werden.

Unter dem Begriff "Kulturpflanze" wird eine Pflanze verstanden, die durch das Eingreifen der Menschen zielgerichtet als Nutz- oder Zierpflanze angebaut wird.

Bei der Befallskarte handelt es sich vorzugsweise um eine digitale Karte. Der Begriff "digital" bedeutet, dass die Karte von einer Maschine, in der Regel einem Computersystem, verarbeitet werden kann. Unter "Verarbeitung" werden die bekannten Verfahren zur elektronischen Datenverarbeitung (EDV) verstanden.

Methoden zur Erzeugung von digitalen Karten, auf denen Orte verzeichnet sind, an denen Schadorganismen aufgetreten sind, sind beispielsweise in GB2447681A, US6199000, US 2009/0132132A1 und WO00/23937 beschrieben.

Vorzugsweise wurden die Schadorganismen in der Anbauperiode beobachtet, die der laufenden Anbauperiode unmittelbar vorangegangen ist. In vielen Fällen beträgt die Anbauperiode ein Jahr, so dass die Befallskarte üblicherweise auf Basis des im Vorjahr beobachteten Schädlingsbefalls erzeugt wird. Es ist aber auch denkbar, Informationen über zeitlich weiter zurück liegende Anbauperioden (Jahre) in die Erzeugung der ersten Befallskarte einfließen zu lassen.

Insbesondere, wenn über einen Zeitraum von mehr als einer Anbauperiode Nester von Schadorganismen in dem Feld beobachtet worden sind, ist die Verwendung solcher Informationen vorteilhaft.

Unter dem Begriff "Nest" wird eine Teilfläche eines Feldes verstanden, auf dem ein bestimmter Schadorganismus wiederholt beobachtet wird.

Ein Beispiel stellt das Acker-Fuchsschwanzgras (Alopecurus myosuroides Huds) dar, welches eine Samenverbreitung nahe der Mutterpflanze aufweist (Wilson & Brain, 1991). Hierbei sind die Unkrautnester stabil bzw. wiederkehrend; es können allerdings auch neue hinzukommen. Weitere Beispiele sind Orobranche crenata Forsk in Ackerbohne (Oveisi et al. 2010), *Galium aparine, Viola arvensis* Murr., *Chenopodium album* L., *Polygonum aviculare* L. (s. Übersicht Gerhards R (2010)).

Ein weiteres Beispiel ist der Befall durch Nematoden, der ein räumlich stabiles Muster aufweist (Campos-Herrera et al. 2011, Godefroid et al. 2013, Ortiz et al. 2010).

Ein "räumlich stabiles Muster" bezeichnet eine wiederholt beobachtbare bzw. messbare räumliche Verteilung bzw. Anordnung von Nestern in einem Feld. Ferner kann sich ein räumlich stabiles Muster von Krankheiten und Schädlingen auf i) die Ursache einer Krankheit oder Schädlingsbefalles, ii) auf die Krankheit oder den Schädlingsbefall selbst als auch iii) auf ein Ausprägungsmerkmal einer Krankheit bzw. eines Schädlingsbefalls beziehen. Beispielsweise kann ein Schädling W einen Virus X übertragen, der zu einer Krankheit Y mit dem Symptom Z führt. Es ist denkbar, dass W, X, Y und Z messbar sind und jeweils ein stabiles Muster ergeben.

Insbesondere können diese Muster durch eine Wechselwirkung von Entwicklungszyklus des Krankheitserregers bzw. Schädlings mit weiteren abiotischen Faktoren hervorgerufen werden. Die Erfindung ist daher auch auf Regionen im Feld anzuwenden, die aufgrund ihrer Beschaffenheit einen generell höheren Krankheits- oder Schädlingsdruck aufweisen. Beispiele solcher Beschaffenheitsfaktoren sind Lage bzw. Exposition, Mulden, Boden oder Feldrandbeschaffenheit (z.B. Hecken).

Als Beispiel sei die Septoria-Blattdürre angeführt, die bei günstigen Bedingungen für die Infektion durch Pilzsporen von Septoria Tritici entsteht. Diese günstigen Bedingungen können nun durch eine höhere Feuchte bzw. geringeren Luftaustausch gegeben sein, bedingt durch Exposition, lokale Mulden und/oder Bodenart.

Ein Beispiel für einen Schädling, bei dem wiederkehrende Muster auftreten, ist die Kohlschotenmücke (*Dasineura brassicae*) bei Raps. Durch die geringe Flugbereitschaft ist für einen Befall die Distanz zum Winterwirt maßgeblich. Ein wiederkehrendes Muster ergibt sich hier durch die Lage des Feldes relativ zu der des Winterwirtes als auch zu der des Feldes mit Rapsanbau im Vorjahr.

Ein weiteres Beispiel sind Erreger, deren Befallsdruck durch die Abbaurate von Pflanzenresten im Boden bestimmt wird. Stabile Nester können hier durch lokale Unterschiede im Boden hervorgerufen werden.

Die vorliegende Erfindung ist somit vorzugsweise auf den Befall mit Schadorganismen anzuwenden, bei denen Nester oder Befallsgradienten im Feld beobachtet werden. Ist in der Vergangenheit ein Befall an einer Stelle im Feld beobachtet worden, besteht eine gewisse Wahrscheinlich, dass an dieser Stelle erneut ein Befall auftritt.

Die Erfindung ist aber auch auf den Befall mit Schadorganismen anzuwenden, bei denen keine Nester beobachtet werden. In einem solchen Fall wird die erste Befallskarte herangezogen, um die Faktoren zu ermitteln, die in der Vergangenheit zu einem beobachteten Befall geführt haben. Dabei wird ermittelt, welche Bedingungen an den Befallsstellen geherrscht haben und zwar sowohl vor dem Befall als auch während des Befalls. Durch Hinzuziehen von allgemeinem Wissen über die Schadorganismen und ihre Ausbreitung lassen sich dann Korrelationen ableiten, die zur Vorhersage eines Befallsrisikos dienen können.

Die erste Befallskarte wird verwendet, um das Risiko eines (erneuten) Befalls in der laufenden Anbauperiode vorherzusagen.

In Schritt (C) erfolgt eine Vorhersage für das Risiko, dass in der laufenden Anbauperiode in dem Feld Schadorganismen auftreten (Befallsrisiko).

Unter dem Begriff "Befallsrisiko" wird die Wahrscheinlichkeit des Auftretens einer Krankheit, eines Schädlings oder entsprechender Schäden oder Symptome an der Kulturpflanze sowie auch die Wahrscheinlichkeit des Auftretens von sonstigen, aus einem Befall entstehenden verfahrenstechnischen Nachteilen verstanden. Hierbei bezieht sich das Risiko jeweils auf eine Ausprägungsform der Krankheit, des Schädlings oder von entsprechenden Schäden oder Symptomen an der Pflanze als auch von sonstigen, daraus entstehenden verfahrenstechnischen Nachteilen.

Dieses Risiko wird berechnet. Dazu wird vorzugsweise ein Modell der Ausbreitung der Schadorganismen, die in der ersten Befallskarte verzeichnet sind, erstellt.

Es fließen auch Informationen über einen Befall der Kulturpflanzen mit Schadorganismen in der laufenden Anbauperiode in die Vorhersage ein. Dazu wird in Rahmen der vorliegenden Erfindung eine zweite Befallskarte erstellt (Schritt (B)). In der zweiten Befallskarte sind Orte auf dem Feld verzeichnet, bei denen in der laufenden Anbauperiode Schadorganismen beobachtet worden sind.

Die erste und die zweite Befallskarte können auf Beobachtungen einer Person (in der Regel des Landwirts) oder auf Daten, die durch Sensoren erzeugt wurden, oder auf beidem basieren.

Beobachtungen, die auf Sensoren basieren, sind beispielsweise Fernerkundungsdaten. Fernerkundungsdaten sind digitale Informationen, die aus der Ferne beispielsweise durch Satelliten von der Erdoberfläche gewonnen wurden. Auch der Einsatz von Luftfahrzeugen (unbemannt (Drohnen) oder bemannt) zur Aufnahme von Fernerkundungsdaten ist denkbar.

Durch entsprechende Fernerkundungssensoren werden entweder die Schadorganismen selbst (z.B. Unkräuter und Ungräser) oder ihre Auswirkungen auf die Kulturpflanzen beobachtet (M. S. Moran et al.: Opportunities and Limitations for Image-Based Remote Sensing in Precision Crop Management, Remote Sensing of Environment (1997) 61: 319-346).

Auch Sensoren im Feld oder Sensoren, die an Maschinen zur Bearbeitung der landwirtschaftlichen Fläche (Landmaschinen) angebracht sind, können zur Beobachtung von Schadorganismen eingesetzt werden.

Es ist auch denkbar, zunächst das Befallsrisiko auf Basis der ersten Befallskarte zu berechnen. Werden dabei Teilflächen identifiziert, bei denen aktuell ein hohes Befallsrisiko besteht, können Maßnahmen ergriffen werden, um einen aktuellen Befall zu verifizieren oder falsifizieren. Es ist zum Beispiel denkbar, dass ein Landwirt aufgrund der Vorhersage eines aktuell hohen Befallsrisikos eine computergestützte Mitteilung erhält, er solle die Teilflächen auf einen eventuellen Befall prüfen. Die Prüfung kann augenscheinlich, mit Hilfe von Fernerkundungssensoren, Sensoren im Feld oder Sensoren an einer Landmaschine erfolgen. Diese Beobachtungen sind dann die Grundlage für die zweite Befallskarte. Wird ein akuter Befall festgestellt oder auch nicht festgestellt, fließen diese Beobachtungen als zweite Befallskarte in die weitere (aktualisierte) Vorhersage des Befallsrisikos ein.

Natürlich ist es auch denkbar, im Laufe der gegenwärtigen Anbauperiode weitere Befallskarten (eine dritte, eine vierte,...) zu erstellen und in die Vorhersage einfließen zu lassen. Es ist auch denkbar, den Befall mit Schadorganismen laufend mittels geeigneter Sensoren zu verfolgen und die entsprechenden Informationen in die (laufend aktualisierte) Vorhersage einfließen zu lassen.

Für alle Befallskarten gilt, dass auch die Beobachtung, dass in einer Teilfläche keine Schadorganismen beobachten worden sind, eine wertvolle Information sein kann, die in die Vorhersage des Befallsrisikos einfließen kann.

Vorzugsweise fließen zudem Informationen zum Entwicklungsstand der Kulturpflanzen in die Vorhersage des Befallsrisikos ein. Je nach vorliegendem Entwicklungsstand sind Kulturpflanzen mehr oder weniger anfällig gegenüber einem Befall mit einem Schadorganismus und/oder es treten Schadorganismen überhaupt erst bei Vorliegen eines bestimmten Entwicklungsstandes in Erscheinung.

Die Informationen zum Entwicklungstand der Kulturpflanzen schließen z.B. folgende Informationen ein: Entwicklungsstadium (z.B. BBCH-Code), Wuchshöhe, Blattgröße, Blattform, Blattfarbe, Blattfläche, Aussaattermin, Sorte, vorhandene Biomasse, Ernährungszustand und Gesundheitszustand.

Der BBCH-Code (oder auch BBCH-Skala) gibt Auskunft über das morphologische Entwicklungsstadium einer Pflanze. Die Abkürzung steht offiziell für die "Biologische Bundesanstalt, Bundessortenamt und CHemische Industrie". Die BBCH-Skala dient in der wissenschaftlichen Kommunikation den Fragen der Pflanzenentwicklung und dem optimalen bzw. empfohlenen Einsatzzeitpunkt von Dünge- und Pflanzenschutzmaßnahmen im Nutzpflanzenanbau.

Auch die Informationen zum Entwicklungsstand der Kulturpflanzen können mittels Fernerkundungssensoren und/oder Sensoren im Feld und/oder menschliche Beobachtung und/oder Sensoren an Landmaschinen zusammengetragen werden.

In die Vorhersage des Befallsrisikos fließen ferner vorzugsweise Informationen über teilflächenspezifische Umweltfaktoren ein.

Als "Umweltfaktor" wird ein Element der Umwelt bezeichnet, das mit anderen Elementen (z.B. Lebewesen) in Wechselwirkung steht. Umweltfaktoren können auch als ökologische Faktoren oder Ökofaktoren beschrieben werden.

Meist wird der Umweltfaktor als Beschreibung eines Umwelteinflusses auf einen Organismus verstanden. Dieser kann das Lebewesen fördern oder schädigen.

Die Umweltfaktoren können biotisch oder abiotisch sein. Biotische Faktoren sind Faktoren der lebenden Umwelt, wie beispielsweise Nahrung, Konkurrenten, Feinde, Parasiten und Krankheitserreger. Abiotische Faktoren sind Zustände der Umwelt, die von Lebewesen nicht verursacht oder beeinflusst werden.

Es werden für die Vorhersage solche Umweltfaktoren berücksichtigt, die einen Einfluss auf die Ausbreitung der beobachteten Schadorganismen ausüben können.

Bevorzugte Umweltfaktoren sind: Bodentyp, Bodenbeschaffenheit, Bodenzusammensetzung, Bodenfeuchte, Fruchtfolge, Nährstoffgehalt im Boden, Feldrandbewuchs, Exposition gegenüber Sonneneinstrahlung, Wind und/oder Niederschlagsverhältnisse, der Bewuchs von Nachbarfeldern und das Klima.

Vorzugsweise fließen ferner Informationen zum Wetter in die Vorhersage des Befallsrisikos ein. Die Ausbreitung vieler Schadorganismen (insbesondere Pilze und tierische Schädlinge) hängt insbesondere von der Entwicklung des Wetters während der betrachteten Anbauperiode der Kulturpflanze ab. Dabei können sowohl das Wetter der letzten Tagen und Wochen, Monate und Jahre (Vergangenheit), als auch das aktuelle Wetter (Gegenwart), als auch das erwartete Wetter (Zukunft) maßgeblich für das Auftreten und die Verbreitung von Schadorganismen sein. Insofern umfassen Informationen zum Wetter, die in die Vorhersage des Befallsrisikos einfließen, gemessene Wetterdaten der laufenden Anbauperiode, inter- oder extrapolierte Wetterdaten sowie vorhergesagte Wetterdaten.

Alle Informationen, die in die Vorhersage des Befallsrisikos einfließen, weisen vorzugsweise eine Ortsauflösung auf, die höher ist als das betrachtete Feld, um eine teilflächenspezifische Vorhersage zu ermöglichen. Je höher die Ortsauflösung ist, desto kleiner sind die Teilflächen, für die eine spezifische Vorhersage gemacht werden kann.

Bei dem Modell zur Vorhersage des Befallsrisikos kann es sich einerseits um ein rein regelbasiertes Expertensystem handeln, welches auf Basis vergangener Beobachtungen das Befallsrisiko für aktuell beobachtete Situationen ausgibt. Andererseits kann das Vorhersagemodell auch mechanistisch oder prozessbasiert sein. I.d.R. wird das Vorhersagemodell eine Mischung aus regelbasiertem und prozessbasiertem System sein. So kann z.B. die Blattfeuchte prozessbasiert, das daraus resultierende Infektionsrisiko regelbasiert abgeschätzt werden. Ferner sind rein datengetriebene Vorhersagemodelle denkbar, z.B. auf Basis neuronaler Netzwerke. Prinzipiell ist eine Kombination der oben beschriebenen Modellsysteme denkbar.

Vorzugsweise wird das Befallsrisiko regel- o. prozessbasiert simuliert, wenn ein Nachvollziehen der simulierten Prozesse (z.B. Fehleranalyse) erwünscht ist, das Verständnis der simulierten Prozesse in Form entsprechender Gleichungen vorhanden ist, die Güte der Modellergebnisse einem rein datengetriebenen Modellansatz überlegen ist, oder die erhobene Datengrundlage niedrig ist.

Andererseits kann ein rein datengestützer Ansatz (z.B. deep learning) vorzugsweise verwendet werden, wenn ein Nachvollziehen der simulierten Prozesse (z.B. Fehleranalyse) unbedeutend ist, das Verständnis der simulierten Prozesse in Form entsprechender Gleichungen fehlt, die Güte der Modellergebnisse einem prozess- oder regelbasierten Modellansatz überlegen ist, oder die erhobene Datengrundlage hoch ist. Je nach Modell kann auch die aufzuwendende Rechenleistung entscheidend für die Auswahl eines Modellierungsansatzes sein.

In einem ersten Entwicklungsschritt kann eine Erweiterung eines Entscheidungsunterstützungssystems wie z.B. proPlant (s.o.) der Risikoeinschätzung dienen. In einem zweiten Entwicklungsschritt können prozessbasierte oder gekoppelte Modelle hierzu verwendet werden.

In die Modellierung fließen folgende Parameter ein
a) Wetter: tägliche Niederschlagssummen, Strahlungssummen, Tagesminimum und - maximum der Lufttemperatur sowie Temperatur in Bodennähe sowie Bodentemperatur, Windgeschwindigkeit, u.a.
b) Boden: Bodentyp, Bodentextur, Bodenart, Feldkapazität, Permanenter Welkepunkt, Organischer Kohlenstoff, mineralischer Stickstoffgehalt, Lagerungsdichte, Van-Genuchten-Parameter, u.a.
c) Kulturpflanze: Art, Sorte, sortenspezifische Parameter wie z.B. Spezifischer Blattflächenindex, Temperatursummen, maximale Wurzeltiefe, u.a.
d) Kulturmaßnahmen: Saatgut, Aussaattermin, Aussaatdichte, Aussaattiefe, Düngemittel, Düngemenge, Anzahl an Düngeterminen, Düngetermin, Bodenbearbeitung, Erntetermin, Ernterückstände, Pflanzenschutztermine, Planzenschutzmittel (Art und Ausbringungsmenge/-konzentration), Fruchtfolge, Distanz zum Feld gleicher Kultur im Vorjahr, Bewässerung, u.a.
e) Fernerkundung: Erfassung von Blattfläche o. Biomasse über Fernerkundungsprodukte (z.B. NDVI), Erfassung des Ernährungszustandes, Erfassen von Krankheiten, Erfassen der Wirksamkeit von Pflanzenschutzmaßnahmen, u.a.
f) Befall: Scouting-Parameter zum Schätzen des aktuellen Befallsdrucks oder Epizentrum der Krankheit, Scouting-Parameter zum Erfassen des tatsächlichen Befalls (z.B. Vorjahresbefall), Laborwerte zur Klassifizierung und/oder Quantifizierung der vorhandenen Schaderreger, u.a.
g) Geographie: Geographische Lage, Exposition, Orographie, Höhe, u.a.

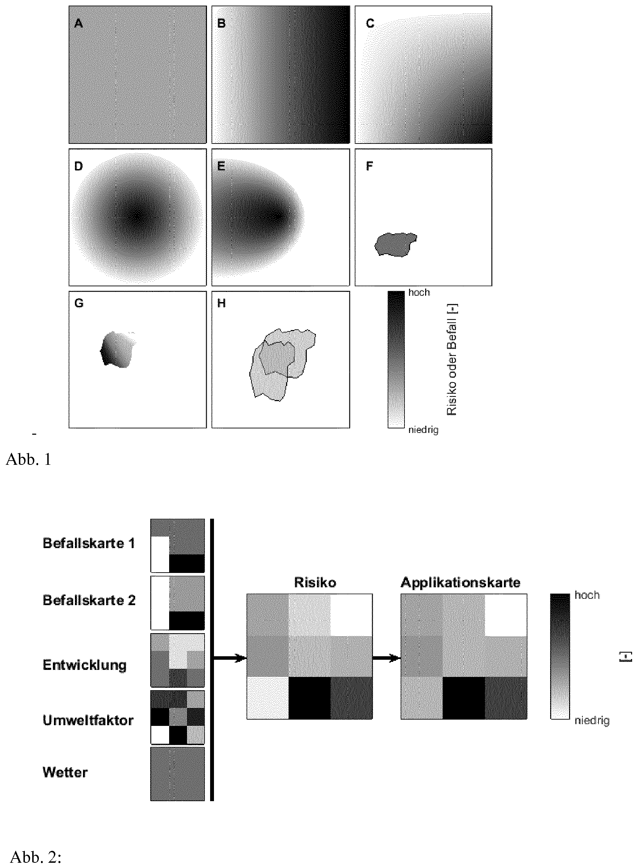

Die Vorhersage erfolgt teilflächenspezifisch (siehe z.B. Abb.1), d.h., das Feld wird in Teilflächen aufgeteilt, für die das jeweilige Befallsrisiko berechnet wird.

Die Aufteilung des Feldes in Teilflächen kann dabei so erfolgen, dass das Feld in eine definierte Anzahl von gleich großen oder nahezu gleich großen Teilflächen aufgeteilt wird.

Vorzugsweise erfolgt die Aufteilung des Feldes in Teilflächen unter Berücksichtigung der räumlichen Verteilung derjenigen Faktoren, die den größten Einfluss auf die Ausbreitung der Schadorganismen ausüben.

Es sei angenommen, dass die Bodenbeschaffenheit einen entscheidenden Einfluss auf die Ausbreitung hat. In diesem Fall kann es sinnvoll sein, die Teilflächen so zu wählen, dass Bereiche in dem Feld mit ähnlicher Bodenbeschaffenheit zu einer Teilfläche zusammengefasst werden, während Bereiche in dem Feld, die sich deutlich in der Bodenbeschaffenheit unterscheiden, in unterschiedlichen Teilflächen separiert werden.

Das Ergebnis des Schritts (C) des erfindungsgemäßen Verfahrens ist eine digitale Karte des Feldes, in der für einzelne Teilflächen ein Risiko für den Befall mit einem oder mehreren Schadorganismen angegeben ist. Die Angabe des Befallsrisikos erfolgt vorzugsweise in Form einer prozentualen Wahrscheinlichkeit. Ist in der aktuellen Anbauperiode z.B. im Rahmen der Erstellung der zweiten Befallskarte ein Befall mit Schadorganismen in einigen Teilflächen beobachtet worden, so beträgt das Befallsrisiko für diese Teilflächen 100 %. Ist hingegen aktuell noch kein Befall beobachtbar, ist das Befallsrisiko geringer als 100 %.

Anstelle der prozentualen Wahrscheinlichkeit eines Befalls oder zusätzlich dazu kann das Befallsrisiko auf der digitalen Karte auch farblich dargestellt werden. Zum Beispiel können diejenigen Teilflächen, für die ein vergleichsweise geringes Befallsrisiko ermittelt worden ist (z.B. kleiner als 20 %), grün eingefärbt sein, während Teilflächen, für die ein vergleichsweise hohe Befallsrisiko ermittelt worden ist (z.B. größer als 80 %), rot eingefärbt sein können.

Vorzugsweise wird das Befallsrisiko in Abhängigkeit der Zeit ermittelt und dargestellt. Das ermöglicht dem Nutzer (z.B. Landwirt) zu erkennen, wann mit einem erhöhten Risiko zu rechnen ist.

Vorzugsweise wird die Vorhersage laufend, insbesondere unter Berücksichtigung der gegenwärtigen Wetterentwicklung, aktualisiert.

In Schritt (D) des erfindungsgemäßen Verfahrens wird auf Basis der teilflächenspezifischen Vorhersage eine teilflächenspezifische Behandlungskarte erstellt.

Unter "Behandlung" werden diejenigen Maßnahmen verstanden, die zu einer Verhinderung des Auftretens oder der Ausbreitung von Schadorganismen und/oder die Reduzierung der Menge an vorhandenen Schadorganismen führen. Die Behandlungsmaßnahmen können sich auf die Kulturpflanzen, das Umfeld der Kulturpflanzen (z.B. den Boden) oder die Schadorganismen beziehen. Insbesondere dann, wenn sich die Maßnahmen auf vorhandene Schadorganismen beziehen, wird vorliegend auch der Begriff Bekämpfung verwendet. Unter dem Begriff "Bekämpfung" wird somit eine Verhinderung der Ausbreitung oder Reduzierung der Menge an vorhandenen Schadorganismen bezeichnet. Im Fall der Unkräuter/Ungräser bezieht sich der Begriff "Menge" beispielsweise auf die Biomasse, die in Form von Unkräutern/Ungräsern vorliegt. Unter dem Begriff "Menge" kann aber insbesondere bei einer Krankheit auch die Menge an Kulturpflanzen verstanden werden, die bereits Krankheitssymptome aufweist.

In der Regel erfolgt die Behandlung durch die Applikation eines oder mehrerer Pflanzenschutzmittel.

Unter dem Begriff "Pflanzenschutzmittel" wird ein Mittel verstanden, mit dem Schadorganismen wirksam bekämpft und/oder ihre Ausbreitung verhindert werden kann. Ein Pflanzenschutzmittel ist üblicherweise eine Formulierung, die einen oder mehrere Wirkstoffe gegen einen oder mehrere Schadorganismen enthält. Handelt es sich bei den Schadorganismen beispielsweise um Unkräuter oder Ungräser, so ist der Wirkstoff zur Bekämpfung der Unkräuter oder Ungräser ein Herbizid und das Pflanzenschutzmittel eine Herbizidformulierung. Handelt es sich bei den Schadorganismen beispielsweise um einen Pilz, so ist der Wirkstoff zur Bekämpfung des Pilzes ein Fungizid und das Pflanzenschutzmittel eine Fungizidformulierung. Als synonym zum Begriff "Pflanzenschutzmittel" wird hier auch der Begriff "Bekämpfungsmittel" verwendet.

Denkbar ist auch eine Applikation von Wachstumsregulierern anstelle von oder in Kombination mit Pflanzenschutzmitteln, wenn dies dem Kulturverfahren dienlich ist und das Befallsrisiko auf Feldebene oder teilflächenspezifisch senkt. Insofern sollen hier auch Wachstumsregulierer unter den Begriff Pflanzenschutzmittel fallen und eine Behandlung einer Teilfläche soll hier auch die Applikation eines Wachstumsregulierers auf der Teilfläche umfassen.

Die Bekämpfung von Schadorganismen mit entsprechenden Pflanzenschutzmitteln auf chemischer und/oder biologischer Basis kann auch durch physikalische/mechanische Bekämpfungsmethoden ergänzt oder ersetzt werden.

Unter physikalischer Entfernung (oder auch mechanischer Entfernung) wird verstanden, dass beispielsweise das Unkraut/Ungras als Schadorganismus entweder vollständig entfernt wird, oder Teile davon entfernt werden, so dass das Unkraut/Ungras nicht mehr lebensfähig ist und abstirbt. Im Gegensatz zur Bekämpfung des Unkrauts/Ungrases mit einem Herbizid, was als chemische Bekämpfung bezeichnet werden kann, wird bei der physikalischen/mechanischen Bekämpfung kein chemisches oder biologisches Mittel appliziert. Die physikalische/mechanische Bekämpfung übt daher auch keinen Selektionsdruck auf die Unkräuter/Ungräser aus, ist jedoch oftmals aufwändiger und teurer als die Applikation von Herbiziden.

Unter einer physikalischen/mechanisch Bekämpfung soll auch beispielsweise eine Bewässerung verstanden werden, mit der beispielsweise Unkräuter gewünscht zum Auflaufen gebracht werden, um sie dann gezielt zu eliminieren. Unter einer physikalischen/mechanisch Bekämpfung soll zudem auch ein Abflammen der Schadorganismen verstanden werden.

Es ist beispielsweise denkbar, chemische und physikalische Verfahren abwechselnd anzuwenden.

Es ist auch denkbar, dass ein Teil einer Fläche chemisch, ein anderer Teil physikalisch behandelt wird.

Denkbar ist aber auch eine kombinierte Variante in einem Arbeitsgang, z.B. wenn der Einsatz von Chemikalien aufgrund gesetzlicher Reglungen begrenzt ist oder eine Kombination von Schadorganismen vorliegt, bei der eine kombinierte Bekämpfung mit mechanischen und chemischen Mitteln die besten Erfolgsaussichten hat. Die kombinierte Anwendung physikalischer und chemischer Verfahren kann auch sinnvoll sein, wenn die Kombination einen synergistischen Effekt ausübt.

In der Behandlungskarte ist angegeben, auf welchen Teilflächen Maßnahmen ergriffen werden sollen, um den Befall mit Schadorganismen zu verhindern, die Ausbreitung bestehender Schadorganismen zu verhindern oder die Menge an bestehenden Schadorganismen zu reduzieren.

Umfasst die Behandlung die Applikation eines oder mehrerer Pflanzenschutzmittel, so wird neben oder anstelle des Begriff "Behandlungskarte" auch der Begriff "Applikationskarte" verwendet.

In der Applikationskarte ist angegeben, auf welchen Teilflächen des Feldes, welche Mengen eines oder mehrerer ausgewählter Pflanzenschutzmittel appliziert werden sollen, um die Ausbreitung von Schadorganismen zu verhindern und/oder Schadorganismen zu bekämpfen.

Vorzugsweise handelt es sich bei der Behandlungskarte und der Applikationskarte um digitale Karten.

Es ist denkbar, dass eine Behandlung überall dort erfolgen soll, wo während der laufenden Anbauperiode Schadorganismen beobachtet worden sind.

Ebenso ist es denkbar, eine Behandlung in der Behandlungskarte nur für diejenigen Teilflächen vorzusehen, bei denen die beobachteten Schadorganismen eine Schadschwelle überschritten haben.

"Schadschwelle" ist ein Begriff aus der Landwirtschaft, der Forstwirtschaft und dem Gartenbau. Er gibt die Befallsdichte mit Schaderregern, Krankheiten oder den Besatz mit Unkräutern an, ab denen eine Bekämpfung wirtschaftlich sinnvoll wird. Bis zu diesem Wert ist der wirtschaftliche Mehraufwand durch eine Bekämpfung größer als der zu befürchtende Ernteausfall. Übersteigt der Befall oder die Verunkrautung diesen Wert, werden die Bekämpfungskosten durch den zu erwartenden Mehrertrag zumindest ausgeglichen.

Je nach dem Wesen eines Schädlings oder einer Krankheit kann die Schadschwelle sehr unterschiedlich sein. Bei Schädlingen oder Krankheiten, die nur mit großem Aufwand und mit negativen Begleiterscheinungen für die weitere Produktion zu bekämpfen sind, kann die Schadschwelle sehr hoch sein. Kann jedoch schon ein geringer Befall zu einem Ausbreitungsherd werden, der die gesamte Produktion zu vernichten droht, kann die Schadschwelle sehr niedrig sein.

Im Stand der Technik finden sich viele Beispiele zur Ermittlung von Schadschwellen (siehe z.B. Claus M. Brodersen: Informationen in Schadschwellenmodellen, Berichte der GIL, Band 7, Seiten 26 bis 36, http://www.gil-net.de/Publikationen/7_26.pdf).

In vielen Fällen ist es erforderlich, Schadorganismen präventiv zu bekämpfen. Das bedeutet, dass Teilflächen, bei denen ein hohes Risiko für den Befall mit einem Schadorganismus ermittelt worden ist, in die Applikationskarte als "mit einem oder mehreren Pflanzenschutzmitteln zu behandelnde Teilflächen" aufgenommen werden, auch wenn aktuell kein Befall registriert wird. In einem solchen Fall ist es aus wirtschaftlicher und/oder ökologischer Sicht besser, einen Befall gar nicht erst aufkommen zu lassen, als zu warten, bis der Befall akut ist, um ihn dann zu bekämpfen.

Dementsprechend werden in einer Ausführungsform der vorliegenden Erfindung in der Applikationskarte Teilflächen als "mit einem oder mehreren Pflanzenschutzmitteln zu behandelnde Teilflächen" spezifiziert, für die eine Befallsrisikoschwelle überschritten ist.

In einer bevorzugten Ausführungsform wird die Befallsrisikoschwelle in analoger Weise wie die Schadschwellen ermittelt. Vorzugsweise wird dabei das Befallsrisiko einer Teilfläche mit dem prozentualen Flächenanteil der Teilflächen, die von einem hundertprozentigen Befall betroffen ist, gleichgesetzt. Dies sei an einem Beispiel erläutert.

Es sei angenommen, dass für eine Teilfläche in der Größe von 1 ha ein Befallsrisiko von 30 % ermittelt worden ist. Für die Berechnung der Befallsrisikoschwelle wird das 30-%ige Befallsrisiko in den theoretischen Fall überführt, dass 30 % der Teilfläche (1 ha · 30 % = 0,3 ha) mit dem Schadorganismus befallen ist und der Rest (70 %, entspricht einer Fläche von 1 ha · 70 % = 0,7 ha) nicht befallen ist. Als Kosten für die Behandlung werden die Kosten für die Behandlung der gesamten Fläche herangezogen (und nicht nur der befallene Anteil von 30 %). Es wird nun ermittelt, ab welchem Befallsrisiko es aus wirtschaftlicher Sicht günstiger ist, eine Behandlung der gesamten entsprechenden Teilfläche vorzunehmen als den theoretisch befallenen Anteil aufgeben zu müssen.

In der Applikationskarte ist angegeben, welche Teilflächen behandelt werden sollen. Es ist vorzugsweise auch angegeben, mit welchem/welchen Pflanzenschutzmittel/Pflanzenschutzmitteln die jeweiligen Teilflächen behandelt werden sollen.

Im einfachsten Fall handelt es sich bei der Applikationskarte um eine so genannte "on/off-Karte", bei der lediglich angegeben ist, an welchen Stellen ein oder mehrere Pflanzenschutzmittel zum Einsatz kommen sollen.

Vorzugsweise ist die jeweilige Menge des einzusetzenden Pflanzenschutzmittels angegeben. In manchen Fällen wird mit zunehmender Biomasse oder Blattfläche der angebauten Kulturpflanzen mehr Pflanzenschutzmittel eingesetzt. Der Mehraufwand kann hierbei durch eine höhere Konzentration des Wirkstoffs in dem Pflanzenschutzmittel, durch eine größere Menge an Pflanzenschutzmittel oder durch beide Maßnahmen realisiert werden. In einer bevorzugten Ausführungsform ist für die zu behandelnden Teilflächen sowohl die Menge des Pflanzenschutzmittels als auch die Konzentration des Wirkstoffs angegeben.

In der Applikationskarte ist die Behandlung von Teilflächen des Feldes für einen Zeitpunkt in der Zukunft vorgesehen. Vorzugsweise fließen in die Applikationskarte daher auch die für den Applikationszeitpunkt vorhergesagten Werte derjenigen Faktoren ein, die einen Einfluss auf die Wirksamkeit des/der verwendeten Pflanzenschutzmittel haben.

So ist es beispielsweise denkbar, dass die Temperatur und/oder die Bodenfeuchte und/oder der Entwicklungsstand der Kulturpflanze einen Einfluss auf die Wirksamkeit haben. Es ist zum Beispiel denkbar, dass ein Wirkstoff bei einer höheren Temperatur und einer höheren Bodenfeuchte schneller abgebaut wird als bei einer niedrigeren Temperatur und einer niedrigeren Bodenfeuchte. Daher kann es sein, dass unter entsprechenden Bedingungen eine erhöhte Menge an Wirkstoff erforderlich ist, um einen gewünschten Effekt zu erzielen. Dementsprechend werden die Bedingungen für den Applikationszeitpunkt vorhergesagt und die Menge des Pflanzenschutzmittels und/oder Konzentration des Wirkstoffs in dem Pflanzenschutzmittel an diese Bedingungen angepasst.

Denkbar ist auch, dass für verschiedene Zeitpunkte in der Zukunft die herrschenden Bedingungen vorhergesagt werden, um dann zu entscheiden, welcher Zeitpunkt der günstigste Zeitpunkt für eine Applikation ist. Liegen beispielsweise zu einem ersten Zeitpunkt Bedingungen vor, die eine erhöhte Menge an Pflanzenschutzmittel erfordern, als die Bedingungen, die zu einem zweiten Zeitpunkt vorliegen, kann es sein, dass es wirtschaftlich günstiger ist, die Applikation zum zweiten Zeitpunkt vorzunehmen.

In einer weiteren bevorzugten Ausführungsform wird die Menge des Pflanzenschutzmittels und/oder die Konzentration des Wirkstoffs in dem Pflanzenschutzmittel in Abhängigkeit des Befallsrisikos festgelegt. Ist das Befallsrisiko für eine erste Teilfläche höher als für eine zweite Teilfläche, so wird auf der ersten Teilfläche mehr Pflanzenschutzmittel und/oder ein Pflanzenschutzmittel mit höherer Wirkstoffkonzentration ausgebracht als auf der zweiten Teilfläche.

Die Auswahl der Pflanzenschutzmittel erfolgt vorzugsweise auf Basis aller zu bekämpfenden Schadorganismen. Das bedeutet, dass nicht zwangsläufig für jeden einzelnen Schadorganismus, der bekämpft werden soll, ein speziell für diesen Schadorganismus geeignetes Bekämpfungsmittel ausgewählt wird. Vielmehr werden Pflanzenschutzmittel ausgewählt, die für die vorliegende Kombination von Schadorganismen am besten geeignet sind.

Dies sei anhand der folgenden Beispiele erläutert, bei dem zwei Unkräuter (Unkraut 1 und Unkraut 2) auf derselben Teilfläche eines Feldes auftreten.
Beispiel 1: Unkraut 1 und Unkraut 2 sind empfindlich gegenüber Herbizid 1 → Herbizid 1 wird appliziert.
Beispiel 2: Unkraut 1 ist empfindlich gegenüber Herbizid 1 und Unkraut 2 ist empfindlich gegenüber Herbizid 2 und es ist kein einsetzbares Herbizid bekannt, das sowohl gegen Unkraut 1 als auch gegen Unkraut 2 wirkt → Herbizid 1 und Herbizid 2 werden appliziert.
Beispiel 3: Unkraut 1 ist empfindlich gegenüber Herbizid 1 und Unkraut 2 ist empfindlich gegenüber Herbizid 2 und es ist ein einsetzbares Herbizid 3 bekannt, das gegen Unkraut 1 als auch Unkraut 2 wirkt → Es kann entweder Herbizid 3 allein oder Herbizid 1 in Kombination mit Herbizid 2 appliziert werden. Die Wahl erfolgt vorzugsweise auf Basis der effizienteren Bekämpfung.

Beispielsweise werden bei der Bekämpfung des Ungrases Ackerfuchsschwanz folgende Bekämpfungsmittel verwendet: Bei der Herbstanwendung ab BBCH Stadium 11 wird eine Sulfonylmischung bestehend aus den Wirkstoffen Mesosulfuron und Iodusulforon (vorzugsweise plus Safener) eingesetzt. Bei Wirkstoffwechsel werden dann Propoxycarbazone oder Pyroxsulam und Florasulam verwendet. Wenn im Frühjahr das Ungras wiederholt die Schadschwelle überschreitet, dann wird auch im Frühjahr eine Behandlung mit beispielsweise den Wirkstoffen Mesosulfuron und Iodusulforon (plus Safener) durchgeführt. Neben der Gruppe der ALS-Hemmer gibt es auch eine andere Wirkstoffgruppe, die der ACCase-Hemmer mit den sogenannten FOPS. Die Art des Wirkstoffes und die Ausbringungsmenge hängen von Art des Unkrautes oder Ungrases ab, der Anzahl der Pflanzen pro m² oder Biomasse des Unkrautes oder Ungrases und dem Grad der Resistenz ab.

Denkbare Beispiele für Applikationskarten sind demnach:
- Die Applikationskarte ist eine on/off-Karte in Abhängigkeit des Befallrisikos.
- Die Applikationskarte ist eine on/off-Karte in Abhängigkeit des Befallsrisikos, wobei innerhalb einer "on"-Teilfläche variabel in Abhängigkeit der vorhandenen Biomasse appliziert wird.
- Die Applikationskarte enthält Anweisungen zur variablen Pflanzenschutzmittel-Dosierung direkt in Abhängigkeit des Befallsrisikos.
- Die Applikationskarte enthält Anweisungen zur variablen Pflanzenschutzmittel-Dosierung in Abhängigkeit der Biomasse, wobei die Dosen durch das vorliegende Befallsrisiko modifiziert werden.

Dabei bedeutet der Begriff "in Abhängigkeit" üblicherweise, dass ein positiver linearer Zusammenhang vorliegt: liegt eine doppelte Menge an Biomasse vor, wird die doppelte Menge an PSM appliziert; ist das Befallsrisiko doppelt so hoch, wird die doppelte Menge an PSM appliziert. Es ist aber auch denkbar, dass ein nicht-linearer Zusammenhang vorliegt.

In Schritt (E) des erfindungsgemäßen Verfahrens erfolgt die Behandlung von Teilflächen gemäß der in Schritt (D) erstellten Behandlungskarte.

Im Fall der Erstellung einer Applikationskarte werden dementsprechend eine oder mehrere ausgewählte Pflanzenschutzmittel auf den jeweiligen in der Applikationskarte verzeichneten Teilflächen appliziert und so die Schadorganismen bekämpft.

Es ist denkbar, dass die vorzugsweise digitale Applikationskarte Befehle für eine Applikationsvorrichtung für Pflanzenschutzmittel enthält. Das bedeutet, dass die digitale Applikationskarte oder Teile davon in einen Arbeitsspeicher einer Applikationsvorrichtung geladen werden können, von wo die Befehle an eine Sprühvorrichtung übermittelt werden.

Unter einer Applikationsvorrichtung wird eine maschinelle Vorrichtung zum Applizieren eines Pflanzenschutzmittels auf einem Feld verstanden. Eine solche Applikationsvorrichtung umfasst in der Regel mindestens einen Behälter zur Aufnahme mindestens eines Pflanzenschutzmittels, eine Sprühvorrichtung, mit der das Pflanzenschutzmittel auf dem Feld abgegeben wird und eine Steuereinrichtung, mit der die Förderung des mindestens einen Pflanzenschutzmittels aus seinem Behälter in Richtung Sprühvorrichtung gesteuert wird. Die digitale Applikationskarte wird dementsprechend vorzugsweise in dem Arbeitsspeicher der Steuereinheit gespeichert. Die Steuereinheit steht darüber hinaus vorzugsweise mit einem Positionsbestimmungssystem in Verbindung, das die Lage der Applikationsvorrichtung auf dem Feld ermittelt. Vorzugsweise setzt die Steuereinrichtung den Applikationsprozess dann in Gang, wenn auf der digitalen Applikationskarte verzeichnet ist, dass an einem Ort eine Applikation erfolgen soll und wenn das Positionsbestimmungssystem meldet, dass sich die Applikationsvorrichtung gerade an diesem Ort befindet.

In einer Ausführungsform lädt sich ein Mensch (Nutzer) die digitale Applikationskarte in ein mobiles Computersystem, z.B. ein Mobiltelefon (Smartphone), das über einen GPS-Empfänger verfügt. Während der Nutzer über das Feld geht, zeigt ihm das mobile Computersystem anhand einer grafischen Abbildung des Feldes an, wo er sich jeweils befindet und an welchen Stellen er manuell ein oder mehrere Bekämpfungsmittel sprühen (applizieren) soll. Er sprüht dann manuell an den Stellen, an denen die Applikationskarte einen entsprechenden Hinweis enthält. Falls der Nutzer ein Bekämpfungsmittel an einer Stelle appliziert, ist es denkbar, dass über eine entsprechende Sensorik dem mobilen Computersystem eine Rückmeldung über den erfolgten Applikationsprozess übermittelt und der erfolgte Applikationsprozess gespeichert wird. Es ist auch denkbar, dass der erfolgte Applikationsprozess auf dem mobilen Computersystem angezeigt wird, damit der Nutzer erkennen kann, an welchen Stellen er bereits appliziert hat. Ferner ist denkbar, dass die auf dem mobilen Computersystem erfassten Daten sofort oder zu einem späteren Zeitpunkt an ein stationäres Computersystem (z.B. einem Server) übermittelt und dort gespeichert werden. In jedem Fall wird die erfolgte Applikation für jede Teilfläche in der Weise in der digitalen Applikationskarte erfasst, dass die Zahl *N* der (noch) zu tätigenden Applikationen (Behandlungen) um eins vermindert wird.

Denkbar ist auch, dass ein Mensch mit einem Fahrzeug über das Feld fährt, die jeweilige Position des Fahrzeugs mittels GPS-Empfänger erfasst wird, und auf Basis der digitalen Applikationskarte Befehle an eine Sprühvorrichtung am Fahrzeug übermittelt werden, wenn sich das Fahrzeug an einem Ort auf dem Feld befindet, an dem gemäß Applikationskarte eine Applikation eines oder mehrerer Bekämpfungsmittel erfolgen soll, woraufhin die entsprechende Applikation automatisch erfolgt.

Denkbar ist auch, dass die Applikation eines oder mehrerer Bekämpfungsmittel vollautomatisch erfolgt: eine unbemannte Maschine bewegt sich GPS-gestützt über das Feld und appliziert an den Stellen auf dem Feld, an denen in der digitalen Applikationskarte eine entsprechende Applikation vorgesehen ist.

Insbesondere ist ein Einsatz der Erfindung in Kombination mit weiteren bzw. herkömmlichen Applikationsmethoden denkbar. Ein Beispiel ist eine einheitliche Behandlung des gesamten Feldes mit einer ersten Applikation und eine variable Applikation entsprechend dieser Erfindung in einer zweiten Applikation.

Die Erfindung ist schematisch anhand von Beispielen in den Abbildungen 1 und 2 dargestellt.

Abb. 1: Darstellung ausgewählter Beispiele verschieden räumlich ausgeprägter Risiko- oder Befallsfaktoren von Krankheiten oder Schädlingen auf dem Feld.
A: Einheitliches Risiko oder Befall;
B: Gradient ausgehend von einer Seite des Feldes oder jenseits des Feldes;
C: Gradient ausgehend von einer Ecke des Feldes oder jenseits des Feldes;
D: Gradient radial ausgehend von einem Epizentrum;
E: Gradient radial ausgehend von einem Epizentrum mit Drift;
F: Nest mit homogenem Risiko oder Befall;
G: Nest mit Gradient;
H: Zwei überlappende Nester mit jeweils homogenem Risiko oder Befall.

Weitere Risiko- oder Befallsfaktoren sind möglich (z.B. überlappende Gradienten zweier Krankheitsfaktoren, überlappende Nester mit Gradienten, multiple punktuelle Risiken, etc.)

### Abb. 2: Schematische Darstellung des Ablaufs des erfindungsgemäßen Verfahrens

In einem ersten Schritt wird ein Befallsrisiko aus aktuellen und historischen Daten, inklusive langfristigen Risikovektoren, mithilfe von Modellen geschätzt.

In einem zweiten Schritt wird eine entsprechende Applikationskarte erstellt.

In dem Beispiel wird oberhalb eines Risikogrenzwertes variabel Pflanezschutzmittel appliziert, innerhalb eines unteren Risikobereiches wird eine minimale Applikationsdosis angesetzt, unterhalb eines niedrigeren Grenzwertes wird nicht appliziert (weiße Kachel in Applikationskarte). Die Auflösung der Applikation entspricht der räumlichen Auflösung der Risikofaktoren.

### Literatur

Hoffmann H, Zhao G, Asseng S, Bindi M, Biemath C, Constantin J, Coucheney E, Dechow R, Doro L, Eckersten H, Gaiser T, Grosz B, Heinlein F, Kassie BT, Kersebaum K-C, Klein C, Kuhnert M, Lewan E, Moriondo M, Nendel C, Priesack E, Raynal H, Roggero PP, Rötter RP, Siebert S, Specka X, Tao F, Teixeira E, Trombi G, Wallach D, Weihermüller L, Yeluripati J, Ewert F. 2016. Impact of spatial soil and climate input data aggregation on regional yield simulations. PLoS ONE 11(4): e0151782. doi:10.1371/journal.pone.0151782.
Johnen A., Williams I.H., Nilsson C., Klukowski Z., Luik A., Ulber B. 2010. The proPlant Decision Support System: Phenological Models for the Major Pests of Oilseed Rape and Their Key Parasitoids in Europe. In: Biocontrol-Based Integrated Management of Oilseed Rape Pests. Ed.: Ingrid H. Williams. Tartu 51014, Estonia. ISBN 978-90-481-3982-8. p. 381 - 403.
Knight J.D. 1997. The role of decision support systems in integrated crop protection. Agriculture, Ecosystems and Environment 64, 157-163.
Knight J.D., Mumford J.D. 1994. Decision Support Systems in Crop Protection. Outlook on Agriculture 23, 281-285.
Newe M., Meier H., Johnen A., Volk T. 2003. proPlant expert.com - an online consultation system on crop protection in cereals, rape, potatoes and sugarbeet. EPPO Bulletin 33, 443-449.
Parry H.R., Aurambout J.P., Kriticos D.J. 2011. Having your cake and eating it: A modelling framework to combine process-based population dynamics and dispersal simulation. 19th International Congress on Modelling and Simulation, Perth, Australia, 12-16 December 2011. http://mssanz.org.au/modsim2011. Modsim Proceedins 2535-2541.
Peterson R.K.D, Higley L.G. 2001. Biotic Stress and Yield Loss. CRC Press LLC, 2000 N.W. Corporate Blvd., Boca Raton, Florida 33431, USA. ISBN 0-8493-1145-4.
Savary S., Stetkiewicz S., Brun F., Willocquet L. 2015. Modelling and mapping potential epidemics of wheat diseases-examples on leaf rust and Septoria tritici blotch using EPIWHEAT. Eur J Plant Pathol 142, 771-790.
Willocquet L., Aubertot J.N., Lebard S., Robert C., Lannou C., Savary S. 2008. Simulating multiple pest damage in varying winter wheat production situations. Field Crops Research 107, 12-28.

## Patentansprüche

1. Verfahren zur Bekämpfung von Schadorganismen in einem Feld, in dem Kulturpflanzen angebaut werden, wobei das Verfahren folgende Schritte umfasst:
(A) Erstellen einer ersten Befallskarte, wobei in der ersten Befallskarte Teilflächen in dem Feld verzeichnet sind, in denen in einer vergangenen Anbauperiode ein Befall mit Schadorganismen beobachtet worden ist, und
(B) Erstellen einer zweiten Befallskarte, wobei in der zweiten Befallskarte Teilflächen in dem Feld verzeichnet sind, in denen in der laufenden Anbauperiode ein Befall mit Schadorganismen beobachtet worden ist,
und
(C) teilflächenspezifische Vorhersage des Befallsrisikos der Kulturpflanzen mit Schadorganismen für die laufende Anbauperiode, wobei die Vorhersage
- auf Basis der ersten Befallskarte und auf Basis der zweiten Befallskarte und
- auf Basis von teilflächenspezifischen Informationen zum Entwicklungsstand der Kulturpflanzen und/oder auf Basis von teilflächenspezifischen Umweltfaktoren
und
- auf Basis von Wetterinformationen,
erfolgt,
und
(D)Erstellen einer Behandlungskarte, wobei in der Behandlungskarte angegeben ist, welche Teilflächen des Feldes behandelt werden sollen, um die Ausbreitung von Schadorganismen zu verhindern und/oder Schadorganismen zu bekämpfen, wobei die Behandlungskarte
- auf Basis der Vorhersage des Befallsrisikos für die laufende Anbauperiode erstellt, und
- auf Basis der für den Zeitpunkt der geplanten Behandlung vorhergesehenen Bedingungen in Bezug auf Wetter, und/oder Entwicklungsstand der Kulturpflanze und/oder Umweltfaktoren erstellt und/oder angepasst wird,
und
(E) Behandeln von Teilflächen des Feldes gemäß der Behandlungskarte,
wobei die Vorhersage in Schritt (C) durch Modellierung der Ausbreitung von Schadorganismen mittels eines regel- oder prozessbasierten Modells erfolgt und die folgenden Parameter in die Modellierung einfließen:
a) Wetter,
b) Boden,
c) Kulturpflanze,
d) Kulturmaßnahmen,
e) Entwicklungsstand der Kulturpflanze,
f) aktueller Befall,
g) Geographie.

2. Verfahren gemäß Anspruch 1, wobei die teilflächenspezifische Vorhersage des Befallsrisikos auf Basis der folgenden Informationen erfolgt:
- auf B asi s der ersten Befallskarte
- zusätzlich auf Basis der zweiten Befallskarte,
und
- auf Basis von teilflächenspezifischen Informationen zum Entwicklungsstand der Kulturpflanzen oder auf Basis von teilflächenspezifischen Umweltfaktoren,
und
- auf Basis von Wetterinformationen.

3. Verfahren gemäß einem der Ansprüche 1 bis 2, wobei die Behandlung in Schritt (E) eine Applikation eines oder mehrerer Pflanzenschutzmittel umfasst.

4. Verfahren gemäß einem der Ansprüche 1 bis 3, wobei in der Behandlungskarte für diejenigen Teilflächen eine Behandlung vorgesehen ist, für die das errechnete Befallsrisiko einen Schwellenwert überschritten hat, ab dem eine Behandlung wirtschaftlich sinnvoll wird.

5. Verfahren gemäß einem der Ansprüche 1 bis 4, wobei in der Behandlungskarte für die zu behandelnden Teilflächen ein Pflanzenschutzmittel und eine Menge und/oder Konzentration an Pflanzenschutzmittel angegeben sind, wobei die Menge und/oder Konzentration in Abhängigkeit der vorhandenen Biomasse errechnet worden ist.

6. Verfahren gemäß einem der Ansprüche 1 bis 4, wobei in der Behandlungskarte für die zu behandelnden Teilflächen ein Pflanzenschutzmittel und eine Menge und/oder Konzentration an Pflanzenschutzmittel angegeben sind, wobei die Menge und/oder Konzentration in Abhängigkeit des jeweils vorliegenden Befallsrisikos errechnet worden ist.

7. Verfahren gemäß einem der Ansprüche 1 bis 4, wobei in der Behandlungskarte für die zu behandelnden Teilflächen ein Pflanzenschutzmittel und eine Menge und/oder Konzentration an Pflanzenschutzmittel angegeben sind, wobei die Menge und/oder Konzentration in Abhängigkeit des jeweils vorliegenden Befallsrisikos und in Abhängigkeit des jeweils vorliegenden Befallsrisikos errechnet worden ist.

8. System zur Bekämpfung von Schadorganismen in einem Feld, in dem Kulturpflanzen angebaut werden, umfassend
(A) eine erste Befallskarte, wobei in der ersten Befallskarte Teilflächen in dem Feld verzeichnet sind, in denen in einer vergangenen Anbauperiode ein Befall mit Schadorganismen beobachtet worden ist, und
(B) eine zweite Befallskarte, wobei in der zweiten Befallskarte Teilflächen in dem Feld verzeichnet sind, in denen in der laufenden Anbauperiode ein Befall mit Schadorganismen beobachtet worden ist,
und
(C) Mittel zur Vorhersage des Befallsrisikos der Kulturpflanzen mit Schadorganismen für die laufende Anbauperiode, wobei die Vorhersage
- auf Basis der ersten Befallskarte und auf Basis der zweiten Befallskarte,
und
- auf Basis von teilflächenspezifischen Informationen zum Entwicklungsstand der Kulturpflanzen und/oder auf Basis von teilflächenspezifischen Umweltfaktoren,
und
- auf Basis von Wetterinformationen,
erfolgt,
und
(D)Mittel zum Erstellen einer Behandlungskarte, wobei in der Behandlungskarte angegeben ist, welche Teilflächen des Feldes behandelt werden sollen, um die Ausbreitung von Schadorganismen zu verhindern und/oder Schadorganismen zu bekämpfen, wobei die Behandlungskarte
- auf Basis der Vorhersage des Befallsrisikos für die laufende Anbauperiode erstellt,
und
- auf Basis der für den Zeitpunkt der geplanten Behandlung vorhergesehenen Bedingungen in Bezug auf Wetter, und/oder Entwicklungsstand der Kulturpflanze und/oder Umweltfaktoren erstellt und/oder angepasst wird,
und
(E) Mittel zur Behandlung von Teilflächen des Feldes gemäß der Behandlungskarte,
wobei die Vorhersage in Schritt (C) durch Modellierung der Ausbreitung von Schadorganismen mittels eines regel- oder prozessbasierten Modells erfolgt und die folgenden Parameter in die Modellierung einfließen:
a) Wetter,
b) Boden,
c) Kulturpflanze,
d) Kulturmaßnahmen,
e) Entwicklungsstand der Kulturpflanze,
f) aktueller Befall,
g) Geographie.

## Claims

1. A method for the control of harmful organisms in a field in which crop plants are grown, wherein the method comprises the following steps:
(A) creation of a first infestation map, wherein in the first infestation map subareas in the field are indicated in which an infestation with harmful organisms has been observed in a past cultivation period, and
(B) creation of a second infestation map, wherein in the second infestation map subareas in the field are indicated in which an infestation with harmful organisms has been observed in the current cultivation period,
and
(C) subarea-specific prediction of the infestation risk to the crop plants with harmful organisms for the current cultivation period, wherein the prediction is made
- on the basis of the first infestation map and on the basis of the second infestation map
and
- on the basis of subarea-specific information on the state of development of the crop plants and/or on the basis of subarea-specific environmental factors
and
- on the basis of weather information,
and
(D) creation of a treatment map, wherein in the treatment map it is stated which subareas of the field are to be treated, in order to prevent the dispersal of harmful organisms and/or to control harmful organisms, wherein the treatment map
- is created on the basis of the prediction of the infestation risk for the current cultivation period,
and
- is created and/or adapted on the basis of the conditions predicted for the time of the planned treatment with regard to weather, and/or development state of the crop plant and/or environmental factors,
and
(E) treatment of subareas of the field in accordance with the treatment map,
wherein the prediction in step (C) is made by modeling of the dispersal of harmful organisms by means of a rule- or process-based model and the following parameters influence the modeling:
a) weather,
b) soil,
c) crop plant,
d) cultivation measures,
e) development state of the crop plant,
f) current infestation,
g) geography.

2. The method according to claim 1, wherein the subarea-specific prediction of the infestation risk is made on the basis of the following information:
- on the basis of the first infestation map,
- additionally on the basis of the second infestation map,
and
- on the basis of subarea-specific information on the state of development of the crop plants, or on the basis of subarea-specific environmental factors,
and
- on the basis of weather information.

3. The method according to one of claims 1 to 2, wherein the treatment in step (E) comprises an application of one or more plant protection agents.

4. The method according to one of claims 1 to 3, wherein in the treatment map a treatment is specified for those subareas for which the calculated infestation risk has exceeded a threshold value beyond which a treatment becomes economically useful.

5. The method according to one of claims 1 to 4, wherein a plant protection agent and a quantity and/or concentration of plant protection agent are stated in the treatment map for the subareas to be treated, wherein the quantity and/or concentration has been calculated as a function of the biomass present.

6. The method according to one of claims 1 to 4, wherein in the treatment map a plant protection agent and a quantity and/or concentration of plant protection agent are stated for the subareas to be treated, wherein the quantity and/or concentration has been calculated as a function of the infestation risk present in each case.

7. The method according to one of claims 1 to 4, wherein in the treatment map a plant protection agent and a quantity and/or concentration of plant protection agent are stated for the subareas to be treated, wherein the quantity and/or concentration has been calculated as a function of the infestation risk present in each case and as a function of the infestation risk present in each case.

8. A system for the control of harmful organisms in a field in which crop plants are grown, comprising
(A) a first infestation map, wherein in the first infestation map subareas in the field are indicated in which an infestation with harmful organisms has been observed in a past cultivation period, and
(B) a second infestation map, wherein in the second infestation map subareas in the field are indicated in which an infestation with harmful organisms has been observed in the current cultivation period,
and
(C) means for the prediction of the infestation risk to the crop plants with harmful organisms for the current cultivation period, wherein the prediction is made
- on the basis of the first infestation map and on the basis of the second infestation map,
and
- on the basis of subarea-specific information on the state of development of the crop plants and/or on the basis of subarea-specific environmental factors,
and
- on the basis of weather information,
and
(D) means for the creation of a treatment map, wherein in the treatment map it is stated which subareas of the field are to be treated, in order to prevent the dispersal of harmful organisms and/or to control harmful organisms, wherein the treatment map
- is created on the basis of the prediction of the infestation risk for the current cultivation period,
and
- is created and/or adapted on the basis of the conditions predicted for the time of the planned treatment with regard to weather, and/or development state of the crop plant and/or environmental factors,
and
(E) means for the treatment of subareas of the field in accordance with the treatment map,
wherein the prediction in step (C) is made by modeling of the dispersal of harmful organisms by means of a rule- or process-based model and the following parameters influence the modeling:
a) weather,
b) soil,
c) crop plant,
d) cultivation measures,
e) development state of the crop plant,
f) current infestation,
g) geography.

## Revendications

1. Procédé de lutte contre des organismes nuisibles dans un champ dans lequel des plantes de culture sont cultivées, le procédé comprenant les étapes suivantes :
(A) établissement d'une première carte d'infestation, des surfaces partielles dans le champ, dans lesquelles une infestation par des organismes nuisibles a été observée au cours d'une période de culture antérieure, étant enregistrées dans la première carte d'infestation et
(B) établissement d'une deuxième carte d'infestation, des surfaces partielles dans le champ, dans lesquelles une infestation par des organismes nuisibles a été observée au cours de la période de culture en cours, étant enregistrées dans la deuxième carte d'infestation, et
(C) prédiction spécifique aux surfaces partielles du risque d'infestation des plantes de culture par des organismes nuisibles pour la période de culture en cours, la prédiction ayant lieu
- sur la base de la première carte d'infestation et sur la base de la deuxième carte d'infestation
et
- sur la base d'informations spécifiques aux surfaces partielles concernant l'état de développement des plantes de culture et/ou sur la base de facteurs environnementaux spécifiques aux surfaces partielles
et
- sur la base d'informations météorologiques ,
et
(D) établissement d'une carte de traitement, les surfaces partielles du champ qui doivent être traitées pour empêcher la propagation d'organismes nuisibles et/ou pour lutter contre des organismes nuisibles étant indiquées dans la carte de traitement, la carte de traitement
- étant établie sur la base de la prédiction du risque d'infestation pour la période de culture en cours
et
- étant établie et/ou adaptée sur la base des conditions prévues pour le moment du traitement planifié en ce qui concerne les conditions météorologiques et/ou l'état de développement des plantes de culture et/ou les facteurs environnementaux
et
(E) traitement de surfaces partielles du champ selon la carte de traitement,
la prédiction dans l'étape (C) ayant lieu par modélisation de la propagation d'organismes nuisibles au moyen d'un modèle basé sur des règles ou sur des processus et les paramètres suivants entrant dans la modélisation :
a) les conditions météorologiques,
b) le sol,
c) les plantes de culture,
d) les mesures de culture,
e) l'état de développement des plantes de culture,
f) l'infestation actuelle,
g) la géographie.

2. Procédé selon la revendication 1, la prédiction spécifique aux surfaces partielles du risque d'infestation ayant lieu sur la base des informations suivantes :
- sur la base de la première carte d'infestation
- en plus sur la base de la deuxième carte d'infestation,
et
- sur la base d'informations spécifiques aux surfaces partielles concernant l'état de développement des plantes de culture ou sur la base de facteurs environnementaux spécifiques aux surfaces partielles
et
- sur la base d'informations météorologiques.

3. Procédé selon l'une des revendications 1 à 2, le traitement dans l'étape (E) comprenant une application d'un ou de plusieurs agents de phytoprotection.

4. Procédé selon l'une des revendications 1 à 3, un traitement étant prévu dans la carte de traitement pour les surfaces partielles pour lesquelles le risque d'infestation calculé est supérieur à une valeur seuil à partir de laquelle un traitement devient économiquement raisonnable.

5. Procédé selon l'une des revendications 1 à 4, un agent de phytoprotection et une quantité et/ou une concentration d'agent de phytoprotection étant indiqués dans la carte de traitement pour les surfaces partielles à traiter, la quantité et/ou la concentration étant calculée(s) en fonction de la biomasse présente.

6. Procédé selon l'une des revendications 1 à 4, un agent de phytoprotection et une quantité ou une concentration d'agent de phytoprotection étant indiqués dans la carte de traitement pour les surfaces partielles à traiter, la quantité et/ou la concentration ayant été calculée(s) en fonction du risque d'infestation qui existe à chaque fois.

7. Procédé selon l'une des revendications 1 à 4, un agent de phytoprotection et une quantité et/ou une concentration d'agent de phytoprotection étant indiqués dans la carte de traitement pour les surfaces partielles à traiter, la quantité et/ou la concentration ayant été calculée(s) en fonction du risque d'infestation qui existe à chaque fois et en fonction du risque d'infestation qui existe à chaque fois.

8. Système de lutte contre des organismes nuisibles dans un champ, dans lequel des plantes de culture sont cultivées, comprenant
(A) une première carte d'infestation, des surfaces partielles dans le champ, dans lesquelles une infestation par des organismes nuisibles a été observée au cours d'une période de culture antérieure, étant enregistrées dans la première carte d'infestation et
(B) une deuxième carte d'infestation, des surfaces partielles dans le champ, dans lesquelles une infestation par des organismes nuisibles a été observée au cours de la période de culture en cours, étant enregistrées dans la deuxième carte d'infestation
et
(C) des moyens de prédiction du risque d'infestation des plantes de culture par des organismes nuisibles pour la période de culture en cours, la prédiction ayant lieu
- sur la base de la première carte d'infestation et sur la base de la deuxième carte d'infestation,
et
- sur la base d'informations spécifiques aux surfaces partielles concernant l'état de développement des plantes de culture et/ou sur la base de facteurs environnementaux spécifiques aux surfaces partielles
et
- sur la base d'informations météorologiques ,
et
(D) des moyens d'établissement d'une carte de traitement, les surfaces partielles du champ qui doivent être traitées pour empêcher la propagation d'organismes nuisibles et/ou pour lutter contre des organismes nuisibles étant indiquées dans la carte de traitement, la carte de traitement
- étant établie sur la base de la prédiction du risque d'infestation pour la période de culture en cours
et
- étant établie et/ou adaptée sur la base des conditions prévues pour le moment du traitement planifié en ce qui concerne les conditions météorologiques et/ou l'état de développement des plantes de culture et/ou les facteurs environnementaux
et
(E) des moyens de traitement des surfaces partielles du champ selon la carte de traitement,
la prédiction dans l'étape (C) ayant lieu par modélisation de la propagation d'organismes nuisibles au moyen d'un modèle basé sur des règles ou sur des processus et les paramètres suivants entrant dans la modélisation :
a) les conditions météorologiques,
b) le sol,
c) les plantes de culture,
d) les mesures de culture,
e) l'état de développement des plantes de culture,
f) l'infestation actuelle,
g) la géographie.
